# EUROPEAN PATENT SPECIFICATION

(11) **EP 2 265 017 B1**
(45) Date of publication and mention of the grant of the patent: **21.10.2015**
(21) Application number: 08873957.8
(22) Date of filing: 04.12.2008
(51) Int. Cl.: H04N 7/173, H04B 1/16, H04H 60/46, H04H 60/72, H04N 5/44, H04H 20/10, H04H 20/26

(54) **TUNING DEVICE MOUNTED ON CAR**
AM AUTO ANGEBRACHTE ABSTIMMUNGSVORRICHTUNG
DISPOSITIF DE SYNTONISATION MONTÉ SUR VÉHICULE

(30) Priority: 15.04.2008 JP 2008105590
(43) Date of publication of application: 22.12.2010
(73) Proprietor: Mitsubishi Electric Corporation, Chiyoda-ku Tokyo 100-8310 (JP)
(72) Inventor: KASAURA, Tsuyoshi, Tokyo 100-8310 (JP); OKUBO, Tadatoshi, Tokyo 100-8310 (JP); SAKATA, Kenji, Tokyo 100-8310 (JP)
(74) Representative: Hoffmann Eitle
(86) International application number: PCT/JP2008/003583
(87) International publication number: WO 2009/128121

(56) References cited:
- WO-A1-00/40012
- JP-A- 2000 115 098
- JP-A- 2001 169 194
- JP-A- 2003 189 218
- JP-A- 2005 109 982
- JP-A- 2006 157 836
- JP-A- 2006 246 158
- JP-A- 2007 189 727
- JP-A- 2008 022 353
- US-A1- 2006 174 269

## Description

### TECHNICAL FIELD

The present invention relates to an onboard tuning device for automatically selecting a broadcast program in accordance with viewing/listening tendency of a user.

### BACKGROUND ART

Recently, since the number of broadcast programs (the number of stations) has increased sharply, it becomes very troublesome to select (tune to) a desired program from a lot of programs. Thus, an automatic program selecting system is proposed which records desired stations and undesired stations of a viewer/listener in advance, and facilitates tuning with simple key operation by displaying a reduced number of programs in accordance with the desire of the viewer/listener (see Patent Document 1, for example). Alternatively, a television set is proposed which displays a list of programs selected according to the desire of the viewer/listener together with keywords indicating the contents of the programs (see Patent Document 2, for example).

Patent Document 1: Japanese Patent Laid-Open No. 2005-217588 (Paragraphs 0017 - 0023, and FIG. 1 and FIG. 2)
Patent Document 2: Japanese Patent Laid-Open No. 2004-3 12627 (Paragraphs 0061 - 0070, and FIG. 1 and FIG. 2)

WO 00/40012 A1 relates to an apparatus for receiving programs from a plurality of channels comprising a tuner for tuning to any of the plurality of channels. The apparatus comprises virtual channel means for creating a user selectable virtual channel. Thus, the user can select a virtual channel broadcasting the programs of the personal channel. The apparatus comprises scheduling means for assigning priority ratings to the programs of the virtual channel, for selecting a first program in favour of a second program when they are broadcasted simultaneously and the first program has higher priority rating than the second program. The EPG module (electronic program guide) uses the information from the SDT (Service Description Table) and EDT (Event Description Table) to generate an on-screen overview of programs scheduled for the channels in the received broadcast streams. It allows the user to select programs to be viewed. References to the selected programs are stored in a memory which can be accessed by the virtual channel module.

### DISCLOSURE OF THE INVENTION

### [Problems to be Solved by the Invention]

However, even it a program fit for the user's preference is extracted as described above, it is still necessary for the user to do tuning operation to view/listen to the desired program. Thus, the user is not yet freed from the tuning operation. In particular, when the device is an onboard one, it is troublesome for a driver that the tuning operation, operation other than driving, is left during driving.

The present invention is implemented to solve the foregoing problem. Therefore it is an object of the present invention to provide an onboard tuning device capable of showing a desired broadcast program to a user without the tuning operation by the user.

### [Means for Solving the Problem]

An onboard tuning device in accordance with the present invention is as defined by claim 1.

### [Advantage of the Invention]

According to the present invention, since it is configured in such a manner as to automatically tune to the broadcast program with the highest fitness among the broadcast programs during the designated time slot, it can implement the onboard tuning device capable of obviating the need for the tuning operation by the user and capable of providing a desired broadcast program to the user. In particular, it can free the driver from the tuning operation having no direct relation to driving, thereby enabling the driver to drive comfortably.

### BRIEF DESCRIPTION OF THE DRAWINGS

FIG. 1 is a block diagram showing a configuration of an onboard tuning device of an example 1 in accordance with the present invention;
FIG. 2 is a flowchart showing the operation of the onboard tuning device of the example 1 in accordance with the present invention;
FIG. 3 is a block diagram showing a configuration of an onboard tuning device of an embodiment 2 in accordance with the present invention;
FIG. 4 is a flowchart showing the operation of the onboard tuning device of the embodiment 2 in accordance with the present invention;
FIG. 5 is a block diagram showing a configuration of an onboard tuning device of an embodiment 3 in accordance with the present invention;
FIG. 6 is a diagram showing viewing/listening schedules of broadcast programs for explaining the operation of the onboard tuning device of the embodiment 3 in accordance with the present invention; and
FIG. 7 is a flowchart showing the operation of the onboard tuning device of the embodiment 3 in accordance with the present invention.

### [Explanation of Reference Numerals]

1 tuner unit (program information acquiring unit, automatic tuning unit); 2 decoder unit (program information acquiring unit); 3 program information extracting unit; 4 preference fitness estimating unit; 5 preference information retaining unit; 6, 26, 36 automatic tuning unit (automatic tuning unit); 7 preference information analyzing unit; 8, 28, 38 video/audio signal control unit (output signal control unit) ; 9 remote signal receiving unit; 10, 20, 30 onboard tuning device; 110 antenna map data file; 120 display unit; 130 remote controller; 240, 340 content retaining unit; 341 content recording/playback unit; 342 content playback device; 343 audio playback device; 351 viewing/listening control unit (viewing/listening adjusting unit); 352 viewing/listening scheduling unit (viewing/listening adjusting unit).

### BEST MODE FOR CARRYING OUT THE INVENTION

### EXAMPLE 1

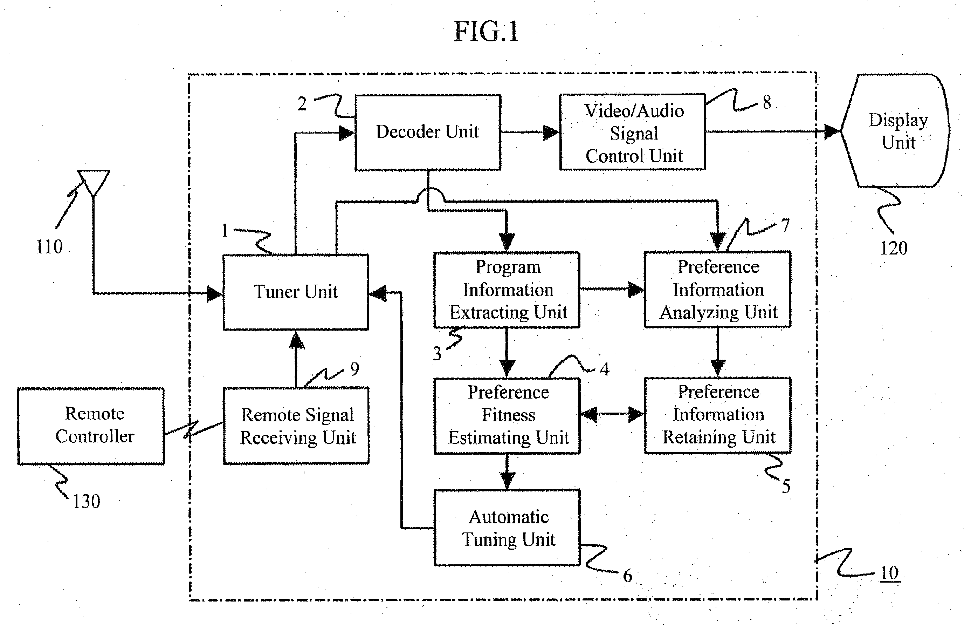

FIG. 1 is a diagram showing a configuration of an onboard tuning device of the example 1. In FIG. 1, the onboard tuning device 10 has a tuner unit 1 for demodulating a broadcast signal supplied from an antenna 110 that receives broadcast signals and for outputting an input signal; a decoder unit 2 for performing decoding processing of the input signal from the tuner unit 1 to separate it into program information and video/audio data to be output; a program information extracting unit 3 for extracting program content information and broadcast time information on each broadcast program from the program list information output from the decoder unit 2; a preference information analyzing unit 7 for detecting tuning operation of a user, for analyzing preference tendency of the user for broadcast programs, and for outputting it as preference information; a preference information retaining unit 5 for retaining as the preference information the preference tendency of the user for broadcast programs the preference information analyzing unit 7 analyzes; a preference fitness estimating unit 4 for outputting fitness of each broadcast program for user's preference as fitness information in terms of ranking based on a numerical grade made according to the preference information the preference information retaining unit 5 retains and to the program content information the program information extracting unit 3 extracts; and an automatic tuning unit 6 for automatically tuning to the broadcast program with the highest fitness information among broadcast programs during the designated time slot in accordance with the broadcast time information the program information extracting unit 3 extracts and with the fitness information the preference fitness estimating unit 4 outputs. In addition, the onboard tuning device 10 has a video/audio signal control unit 8 for supplying a display unit 120 with a video/audio data signal output from the decoder unit 2; and a remote signal receiving unit 9 for receiving a remote control signal from a remote controller 130. Their details will now be described below.

The tuner unit 1 is a device for demodulating a broadcast signal the antenna 110 receives in accordance with a broadcasting scheme, and for outputting it as the input signal. As for the signal of the broadcast program, it selectively extracts and demodulates the broadcast signal of the program from a broadcasting station designated by the tuning signal output from the automatic tuning unit 6 or by the remote tuning signal output from the remote signal receiving unit 9 in response to the operation of the remote controller 130. In addition to the tuning, the tuner unit 1 demodulates a broadcast signal of the program list information (electronic program list) having program information (program title, broadcast channel, program content, genre, broadcast date, broadcast start time, broadcast time period and the like) on each of a plurality of broadcast programs transmitted at every prescribed time, and outputs it as the input signal. In addition, when detecting manual tuning of the user, which will be described later, the tuner unit 1 supplies a signal indicating the manual tuning to the preference information analyzing unit 7.

The decoder unit 2 decodes the input signal the tuner unit 1 outputs, and separates it into the video data and audio data of the channel to which tuning is made and into the program information (referred to as "program list information" from now on) on the plurality of broadcasting stations transmitted at every prescribed time. Then, the decoder unit 2 supplies the program list information to the program information extracting unit 3, and the video data and audio data to the video/audio signal control unit 8. Thus, the tuner unit 1 and the decoder unit 2 operate as a program information acquiring unit for acquiring the program list information.

The program information extracting unit 3 extracts the program content information and the broadcast time information on each broadcast program from the program list information output from the decoder unit 2, and supplies them to the preference fitness estimating unit 4. In addition, it supplies the preference information analyzing unit 7 with the program information on the program to which tuning is made by the manual operation of the user (referred to as "manually tuned program information" from now on).

The preference information analyzing unit 7 detects manual tuning operation of the user, and if the viewing/listening time period of the program to which tuning is made by the operation exceeds a prescribed time period, it extracts, as the user's preference information, a keyword indicating the genre and content of the program from the manually tuned program information on the program, and stores it in the preference information retaining unit 5. For example, if the user selects a 28th CH with the remote controller 130, the remote signal receiving unit 9 outputs the remote tuning signal for tuning to the 28th CH to the tuner unit 1. The tuner unit 1 can detect the manual tuning operation of the user by distinguishing between the remote tuning signal and the tuning signal from the automatic tuning unit 6 even if they are the signals for selecting the same channel. Since the tuner unit 1 supplies the preference information analyzing unit 7 with a signal indicating that the manual tuning is being conducted, when the manually tuned program is viewed/listened to for more than the prescribed time period, the preference information analyzing unit 7 can extract the preference information from the program content information on the program on the assumption that the program matches the user's preference, and store it in the preference information retaining unit 5. As the preference information, the preference information analyzing unit 7 can obtain by extracting information on the genre (type) of the program from the program content information or a keyword from the program content. For example, using the publicly known technique as described in the Patent Document 2, it can give priority to individual keywords or genres according to the number of times of past viewing/listening (extracted frequencies), and can employ them as the preference information.

Incidentally, the preference information analyzing unit 7 can halt the analyzing operation of the preference information in response to a command from the remote controller 130 or with a switch mounted in the main body of the onboard tuning device 10 so as to prevent the operation performed during the time period from being reflected on the preference information. In addition, it can also analyze the preference information for each user and output preference information different from user to user by identifying and setting users at the manual tuning operation or automatic tuning. In other words, it can perform automatic tuning according to the preference information different from user to user. In addition, although the example 1 analyzes the preference information from the manual tuning operation of the user, a configuration is also possible which causes the user to input genres, artist names and the like besides the tuning in advance, and outputs the input information as the preference information.

The preference information retaining unit 5, which is composed of a nonvolatile memory, is a device for storing the preference information output from the preference information analyzing unit 7, and for supplying the stored preference information to the preference fitness estimating unit 4 under the control of the preference fitness estimating unit 4. As for the information stored in the preference information retaining unit 5, the preference information analyzing unit 7 carries out its read/write control, and the preference fitness estimating unit 4 carries out its read control.

According to the preference information stored in the preference information retaining unit 5 and to the program content information on each broadcast program, which is extracted from the program list information by the program information extracting unit 3, the preference fitness estimating unit 4 outputs the fitness of each broadcast program for user's preference as the fitness information in terms of the ranking based on a numerical grade. The fitness information gets a good grade if the number of times of matching is great according to whether the information on the genre extracted from the program content information on each broadcast program matches the genre information retained in the preference information, and according to the number of times of matching between the keywords extracted from the program content of eachbroadcast program and the keywords retained in the preference information. Alternatively, the fitness information can be acquired according to the same method as the degree of recommendation given by expression (4) of Japanese Patent Laid-Open No. 10-257405/1998, for example. Then the preference fitness estimating unit 4 links the broadcast time information with the fitness information for each broadcast program, and supplies to the automatic tuning unit 6.

According to the broadcast time information and fitness information on each broadcast program from the preference fitness estimating unit 4, the automatic tuning unit 6 creates a tuning list of broadcast programs in such a manner that the broadcast program with the highest score fitness information is selected among the broadcast programs during the designated time slot, and supplies the tuner unit 1 with a tuning command to tune to the broadcast program with the highest fitness information among the broadcast programs during the designated time slot. Thus the tuner unit 1 and the automatic tuning unit 6 operate as an automatic tuning unit for automatically tuning to the broadcast program with the highest fitness information among the broadcast programs during the designated time slot according to the broadcast time information and fitness information. Incidentally, the automatic tuning unit 6 can cancel the automatic tuning operation by using a command from the remote controller 130 or a switch mounted in the main body of the onboard tuning device 10.

The video/audio signal control unit 8 has a function of outputting to the display unit 120 the video/audio data signal delivered from the decoder unit 2. Then it controls the data output in such a manner as to uninterruptedly display on the display unit 120 the video and audio of the broadcast program fittest for the user's preference during the designated time slot, to which automatic tuning is made by the automatic tuning unit 6 and tuner 1.

The remote signal receiving unit 9, receiving a remote control signal from the remote controller 130, outputs commands for controlling various operations of the onboard tuning device 10 to the individual units in the onboard tuning device 10. In the example 1, only the output line to the tuner unit 1 is shown as the configuration relating to the tuning operation. Then receiving the remote control signal for tuning from the remote controller 130, the remote signal receiving unit 9 generates the remote tuning signal distinguishable from the tuning signal from the automatic tuning unit 6 and supplies it to the tuner unit 1.

The display unit 120, which has a display unit for displaying the video and a speaker for outputting the audio (neither of them are shown), is a device for receiving the video and audio data signals from the video/audio signal control unit 8 of the onboard tuning device 10, and for outputting the video and audio from the display unit. It is integrated with the onboard tuning device 10.

Although not shown, the remote controller 130 has various kinds of buttons in its surface, and when the user pushes one of the buttons, it encodes a remote controller command assigned to each button, and outputs as a PPM (Pulse Position Modulation) signal of infrared rays from the light-emitting unit at the top not shown. The remote signal receiving unit 9 receives the PPM signal, decodes it to the remote controller command and supplies to the tuner unit 1, thereby enabling not only the manual tuning operation but also other remote control operations.

Next, the operation will be described.

First, the operation of displaying the broadcast program to which tuning is made will be described with reference to FIG. 1.

When the antenna 110 receives broadcast signals, the received broadcast signals are supplied to the tuner unit 1 of the onboard tuning device 10 as an electric signal. The received signals include signals in a frequency band receivable according to the characteristics of the antenna 110 including signals of many channels receivable with the antenna 110. The tuner unit 1 converts all of them to the corresponding data, selects only the received data corresponding to the channel to which tuning is made at this point, and supplies it to the decoder unit 2. The decoder unit 2 converts the received data which is selected and output from the tuner unit 1 to video and audio data, and supplies them to the video/audio signal control unit 8. The audio data and video data passing through the conversion are processed by the video/audio signal control unit 8, and are supplied to the display unit 120 as output data so that the display unit 120 outputs them as the video and audio output. Thus, the user can view/listen to the broadcast program of the channel to which the tuning is done. In addition, when the antenna 110 receives a broadcast signal including the program list information, the tuner unit 1 supplies the data relating to the program list information to the decoder unit 2 regardless of the tuning state at this point.

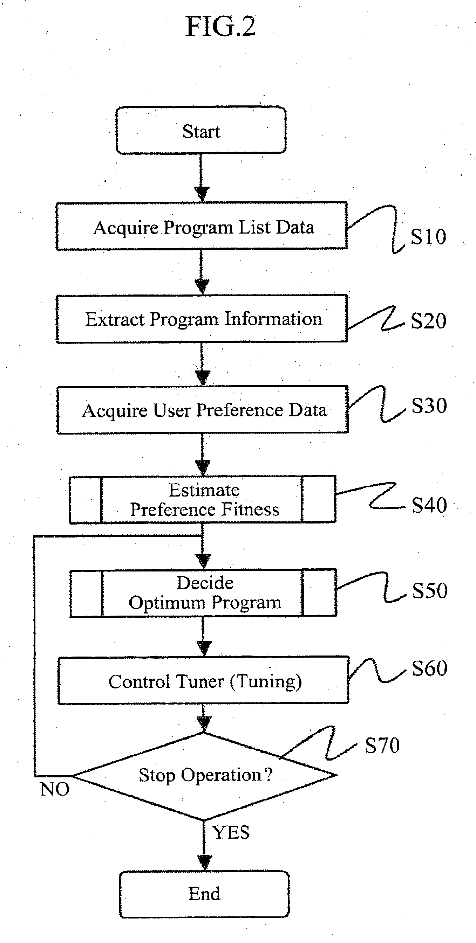

Next, the tuning operation, which is a feature of the onboard tuning device 10 of the example 1, will be described with reference to the flowchart shown in FIG. 2. Incidentally, in example 1, the explanation will be made on the assumption that the preference information has been stored in the preference information retaining unit 5 by analyzing the manual tuning operation which has already been done by the preference information analyzing unit 7.

When the antenna 110 receives the broadcast signals including the program list information, the tuner unit 1 converts all of them to the corresponding data and supplies to the decoder unit 2. Thus, the program information acquiring unit consisting of the tuner unit 1 and the decoder unit 2 obtains the program list information (step S10). The program list information obtained is supplied to the program information extracting unit 3 which extracts the program content information and the broadcast time information on each broadcast program from the program list information. In other words, it extracts the program information on each broadcast program (step S20). The preference fitness estimating unit 4 reads the preference information from the preference information retaining unit 5 (step S30), and ranks on the basis of a numerical grade the fitness of each broadcast program for user's preference as to the plurality of broadcast programs described in the program list information according to the preference information read and the program content information fed from the program information extracting unit 3 (step S40). Then, it outputs the marks given for individual broadcast programs as the fitness information about the respective broadcast programs.

Incidentally, in the example 1, it is assumed in the program list data acquiring step S10 that it acquires the program list data from the broadcast signals every time the onboard tuning device is started. However, when the program list information the onboard tuning device 10 acquired previously has been stored in a storage unit not shown and covers the time slot of the present operation, a configuration is also possible which reads the data stored.

Next, according to the broadcast time information and fitness information on each broadcast program from the preference fitness estimating unit 4, the automatic tuning unit 6 decides the broadcast program with the highest score fitness information among the broadcast programs in the current time slot as the optimum program (step S50). Then, the automatic tuning unit 6 issues the tuning command to the tuner unit 1 to tune to the broadcast program decided. According to the tuning command, the tuner unit 1 performs automatic tuning (step S60). Unless the operation of the onboard tuning device 10 is stopped by turning off the switch or the like ("YES" at step S70), the processing moves to step S50 ("NO" at step S70). At this point of time, the tuning is made to the broadcast program with the highest score fitness information.

Through the operation, the onboard tuning device 10 automatically tunes to the broadcast program fittest for the user's preference among the simultaneous broadcast programs and provides it. Thus the onboard tuning device 10 automatically tunes to the program the user likes best without the tuning operation of the user. Accordingly, when it retains music-loving user's preference information, for example, it operates as though the user were viewing or listening to an all music channel.

As described above, according to the onboard tuning device of the example 1 in accordance with the present invention 10, it is configured in such a manner as to include the program information acquiring unit 1 and 2 for obtaining the program list information; the program information extracting unit 3 for extracting the information on the program content and the information on the broadcast time for each broadcast program from the program list information acquired, and for outputting them as the program content information and the broadcast time information on each broadcast program; the preference information retaining unit 5 for storing the preference tendency of the user for broadcast programs as the preference information; the preference fitness estimating unit 4 for making a ranking based on a numerical grade as to the fitness of each broadcast program for user's preference according to the preference information and program content information, and for outputting as the fitness information; and the automatic tuning unit 6 and 1 for automatically tuning to the broadcast program with the highest fitness information among the broadcast programs during the designated time slot according to the broadcast time information and fitness information. Accordingly, it can obviate the need for the user to carry out the tuning operation and can provide the user with a desired broadcast program. In particular, since the driver is released from the tuning operation without any direct relation with the driving, the driver can concentrate upon driving and hence perform comfortable driving.

In addition, according to the onboard tuning device of the example 1 in accordance with the present invention 10, it is configured in such a manner that when the tuner unit 1 receives the user's manual tuning command based on the operation of the remote controller 130 from the remote signal receiving unit 9, it accepts the manual tuning operation; and that when the preference information analyzing unit 7 detects that the broadcast program to which tuning is made by the manual tuning operation has been viewed/listened to for more than the prescribed time, it reflects the program information on the broadcast program in the preference information. Accordingly, it can automatically analyze the user's preference information from the tuning operation of that user.

Incidentally, according to the example 1, it operates in such a manner that when the broadcast time of the broadcast program with the highest fitness information comes before completing the current broadcast program, it automatically tunes to the next broadcast program. However, a configuration is also possible which tunes to the next station after completing the current broadcast program when the difference between the fitness information on the current broadcast program and the fitness information on the next broadcast program which starts during the broadcast time of the current broadcast program is less than a prescribed value. In this case, as for the programs with small difference between the two pieces of the fitness information, the current broadcast program is not switched in midstream, and hence the user can view/listen to without any uncomfortable feeling. Alternatively, a configuration is also possible which proceeds to step S50 after the broadcast time of the current broadcast program has been completed at step S70. In this case, the program to which automatic tuning is made is displayed until the end of the broadcast.

### EMBODIMENT 2

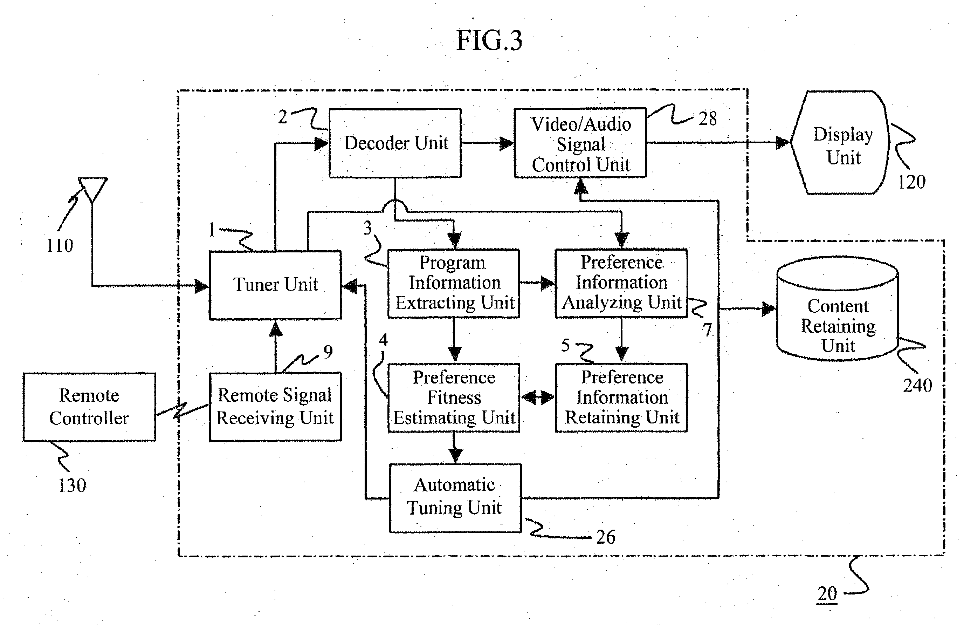

FIG. 3 shows a configuration of an onboard tuning device of the embodiment 2 in accordance with the present invention. The onboard tuning device 20 of the present embodiment 2 includes, besides the onboard tuning device 10 of the example 1, a content retaining unit 240 for storing contents. The content retaining unit 240 is composed of a hard disk drive. However, as long as it can read a content, it is also possible to use a CD (Compact Disc), a DVD (Digital Versatile Disc) or an MD (Mini Disc). In addition, in the present embodiment 2, the content retaining unit 240 is a device that is not only readable but also writable.

The content retaining unit 240 is connected to an automatic tuning unit 26 and a video audio signal control unit 28. Then, the automatic tuning unit 26 connected to the content retaining unit 240 does not tune to a broadcast program with the fitness information less than the prescribed value, and the video/audio signal control unit 28 selects, during a blank time in which there is no broadcast program with the fitness information not less than the prescribed value, a content stored in the content retaining unit 240 and plays it back. Thus, the video/audio signal control unit 28 functions as an output signal control unit which supplies the display unit 120 not only with the video/audio signal of the broadcast program to which tuning is made by the tuner unit 1, but also with the video/audio signal of the content the content retaining unit 240 stores when the tuner unit 1 does not output the data of a broadcast program. In addition, when there are multiple broadcast programs with the fitness information not less than the prescribed value in the same time slot, the video/audio signal control unit 28 functioning as the output signal control unit selects, as a program to be recorded, a broadcast program which is other than the broadcast program to which the automatic tuning unit 26 tunes during the designated time slot and has the fitness information higher than the prescribed value. In this case, the content retaining unit 240 functions as a recording device of the selected program to be recorded.

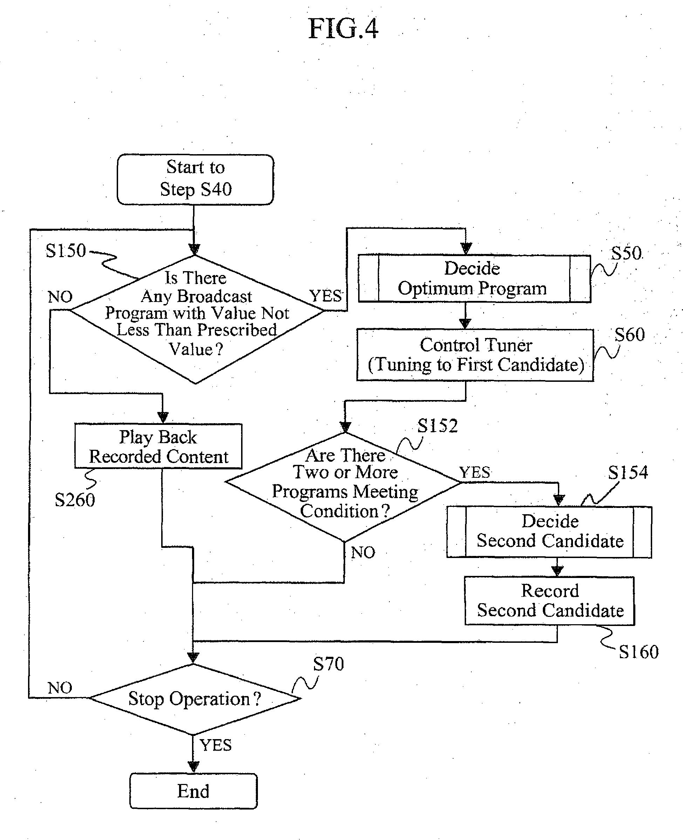

Next, the operation will be described with reference to the flowchart of FIG. 4. Incidentally, as for the state of retaining the preference information before starting the onboard tuning device 20 and as for step S10 - step S40, since they are the same as those of the example 1, their description will be omitted here.

According to the broadcast time information and fitness information on each broadcast program from the preference fitness estimating unit 4, the automatic tuning unit 26 makes a decision as to whether there is a program with the fitness information not less than the prescribed value during each broadcast time slot, the fitness information indicating the degree of matching to the user's preference tendency (step S150).

When there is a broadcast program with a fitness information value greater than the prescribed value ("YES" at S150), the automatic tuning unit 26 decides the broadcast program with the highest score fitness information among the broadcast programs at present as the optimum program (step S50), and issues the tuning command to the tuner unit 1 to tune to the broadcast program decided. According to the tuning command, the tuner unit 1 automatically tunes to the optimum program (step S60).

Next, the automatic tuning unit 26 makes a decision as to whether there are a plurality of broadcast programs with the fitness information value greater than the prescribed value, that is, as to whether two or more broadcast programs fit for the user preference occur in the same time slot (step S152). When there is only one broadcast program with the fitness information value greater than the prescribed value ("NO" at step S152), the processing proceeds to step S70. Unless the operation of the onboard tuning device 10 is stopped such as by turning off the switch ("YES" at step S70), the processing proceeds to step S150 ("NO" at step S70) to successively reselect a broadcast program to be provided next or a content to be played back next.

On the other hand, when there are plural broadcast programs with the fitness information value greater than the prescribed value ("YES" at step S152), deciding the broadcast program with the second highest score fitness information (second candidate) among the broadcast programs at present as the program to be recorded (step S154), the automatic tuning unit 26 issues a tuning command for recording to the tuner unit 1 to tune to the program decided to be recorded independently of and in parallel to the broadcasting station automatically tuned. According to the tuning command for recording, the tuner unit 1 tunes to the automatic tuning program and to the program to be recorded at the same time, and supplies the decoder unit 2 with the broadcast signals of the two programs, the automatic tuning program and the program to be recorded. The decoder unit 2 supplies the video/audio signal control unit 28 with the video and audio signals decoded from the broadcast signals of the two programs, and the video/audio signal control unit 28 supplies the video and audio signals of the automatic tuning program among the input video and audio signals to the display unit 120, and supplies the video and audio signals of the program to be recorded to the content retaining unit 240. Thus, the content of the broadcast program (program to be recorded), which is other than the broadcast program to which the automatic tuning unit 26 tunes in the designated time slot and which has the fitness information higher than the prescribed value, is recorded in the content retaining unit 240 (step S160), and the processing proceeds to step S70.

On the other hand, when there is no broadcast program with the fitness information not less than the prescribed value at step S150 ("NO"at step S150), the automatic tuning unit 26 does not carry out tuning, and supplies the video/audio signal control unit 28 with a signal indicating not to do tuning (no-tuning signal). Receiving the no-tuning signal, the video/audio signal control unit 28 issues a playback command signal to the content retaining unit 240 to play back a content recorded. Receiving the playback command signal, the content retaining unit 240 supplies the video/audio signal control unit 28 with the playback signal of the recorded content. The video/audio signal control unit 28 supplies the display unit 120 with the video and audio data signals of the playback signal of the content output from the content retaining unit 240. Thus, at the blank time in which no broadcast program with the fitness information value greater than the prescribed value is present, a content recorded in the content retaining unit 240 is played back (step S260), and the processing proceeds to step S70. Incidentally, as for the contents to be stored in the content retaining unit 240, besides the contents of the broadcast programs recorded at step S160, contents obtained from commercial programs can also be used. In this case, the content retaining unit can be another recording medium physically separated. In the present embodiment 2, although an example is described which tunes to only one program to be recorded, a configuration is also possible which has an additional number of circuits consisting of the tuner unit 1, decoder unit 2, and video/audio signal control unit, and can record a plurality of broadcast programs at the same time.

Furthermore, as for the contents recorded in the content retaining unit 240, a configuration is also possible which deletes them from the content retaining unit 240 using a step not shown in the flowchart once they have been played back at step S260. In particular, as for the broadcast program recorded at step S160, since it is a program with fitness lower than the automatic tuning program from the beginning, deleting it from the content retaining unit 240 is effective from the viewpoint of disposing the recorded contents. In addition, the lowest limit value of the fitness information of the broadcast program to be recorded at step S160 can be set higher than the lowest limit value (prescribed value) at step S150.

Incidentally, as for the content played back at step S260, when a broadcast of a program with the fitness information higher than the prescribed value begins, the content can be suspended in the middle of the playback of the content because of the automatic tuning of the program. Accordingly, when the user wishes to view/listen to the content through, a configuration is possible which plays back the content from the part suspended at the next blank time. In particular, as for the program to be recorded among the broadcast programs, it is possible to play it back manually afterward without setting it as a playback target at step S260 in which it can be suspended.

As described above, according to the onboard tuning device 20 of the embodiment 2 in accordance with the present invention, it is configured in such a manner that it includes the content retaining unit 240 for storing a content, and the video/audio signal control unit 28 functioning as the output signal control unit for selecting and outputting the content stored in the content retaining unit 240 at the blank time during which no broadcast program with the fitness information not less than the prescribed value is present, and that the automatic tuning unit 26 automatically tunes to the broadcast program with the highest fitness information among the broadcast programs with the fitness information not less than the prescribed value. Accordingly, it does not require the tuning operation of the user, and can provide only broadcast programs with a high degree of matching for the user's preference. Furthermore, it canprovide a content fit for the user' s preference in the so-called blank time slot when there is not any broadcast program with a high degree of matching for the user preference. Thus, it can provide a program or content the user likes without a break without requiring the tuning operation and the driver can concentrate upon driving and can drive comfortably.

In particular, the video/audio signal control unit 28 functioning as the output signal control unit is configured in such a manner that when there are two or more broadcast programs with the fitness information not less than the prescribed value during the designated time slot, it records in the content retaining unit 240 the content of the broadcast program which is other than the broadcast program to which the automatic tuning unit 26 tunes in the designated time slot and which has the fitness information not less than the prescribed value (program to be recorded). Accordingly, it can enable the user to view/listen to a broadcast program that the user was unable to view/listen to though it fits to the user preference.

In addition, since the video/audio signal control unit 28 functioning as the output signal control unit is configured in such a manner that when the content of the broadcast program recorded in the content retaining unit 240 has been played back, it deletes the content of the broadcast program played back from the content retaining unit 240, it can prevent the same broadcast program from being played back repeatedly.

### EMBODIMENT 3

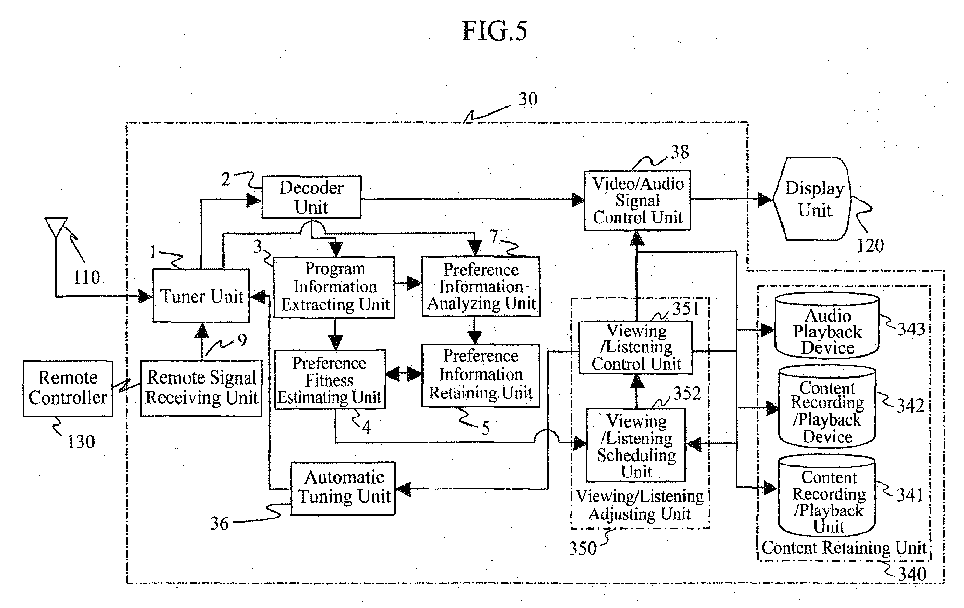

FIG. 5 is a diagram showing a configuration of the onboard tuning device of an embodiment 3 in accordance with the present invention. In the onboard tuning device 3 0 of the present embodiment 3, a content retaining unit 340 comprises a plurality of recording devices, a content recording/playback device 342, an audio playback device 343 and a content recording/playback unit 341 capable of time-shift playback. In particular, as compared with the onboard tuning device 20 of the embodiment 2, it comprises a viewing/listening adjusting unit 350 including a viewing/listening scheduling unit 352 for arranging a viewing/listening schedule of broadcast programs and various contents and a viewing/listening control unit 351 for controlling the content retaining unit 340, an automatic tuning unit 36 and a video/audio signal control unit 38 functioning as the output signal control unit in such a manner as to output the data signal of the broadcast program to which the tuning is made or of the content stored in the plurality of recording devices in accordance with the viewing/listening schedule the viewing/listening scheduling unit organizes.

The content recording/playback device 342, which is a device for playing back a content consisting of video and audio, supplies the video and audio signals of the content it stores to the video/audio signal control unit 38 in response to the control of the viewing/listening control unit 351 of the viewing/listening adjusting unit 350, and supplies the information on the content it stores (content title, content itself, and playback time) to the viewing/listening scheduling unit 352 in response to the control of the viewing/listening scheduling unit 352.

The audio playback device 343, which is a device for playing back a content consisting of audio, supplies the audio signal of the content it stores to the video/audio signal control unit 38 in response to the control of the viewing/listening control unit 351 of the viewing/listening adjusting unit 350, and supplies the information on the content it stores (content title, content itself, and playback time) to the viewing/listening scheduling unit 352.

The content recording/playback unit 341, which is a device capable of recording or playback of the content as the content retaining unit 240 in the embodiment 2, has inparticular a time-shift playback function which enables a broadcast program to be recorded and played back while shifting time. Then, in response to the control of the viewing/listening control unit 351 of the viewing/listening adjustingunit 350, the content recording/playback unit 341 records the video and audio signals of the content of the broadcast program supplied from the video/audio signal control unit 38, supplies the video and audio signals of the content of the broadcast program it stores to the video/audio signal control unit 38, and supplies the program content information and broadcast time information on the content of the broadcast program it stores to the viewing/listening scheduling unit 352.

The viewing/listening scheduling unit 352 arranges a viewing/listening schedule for a prescribed time period (12 hours, for example) from the present time using the broadcast programs with the fitness information not less than the prescribed value and from the contents stored in the content retaining unit 340. In particular, when a blank time occurs in which there is no broadcast program with the fitness information not less than the prescribed value, and when the playback time of the content (blank time content) selected to fill in the blank time exceeds the blank time, the viewing/listening scheduling unit 352 has a function of rearranging the viewing/listening schedule in such a manner as to play back the selected content from the beginning to the end by delaying the viewing/listening time slot of the content of the broadcast program whose broadcast begins right after the blank time to the end of the blank time content.

As for the contents fit for user's preference, the viewing/listening control unit 351 controls the operation of the automatic tuning unit 36, the individual recording devices 341 - 343 of the content retaining unit 340 and the video/audio signal control unit 38 in accordance with the viewing/listening schedule. In particular, as for the content of the broadcast program whose broadcast begins right after the blank time, using the time-shift playback function of the content recording/playback unit 341, it controls in such a manner as to provide the broadcast program from its beginning after completing the playback of the blank time content. In other words, it controls the content retaining unit 240, the automatic tuning unit 36 and the output signal control unit 38 in such a manner as to prevent the content fit for the user's preference from being interrupted in accordance with the viewing/listening schedule.

Next, the operation will be described.

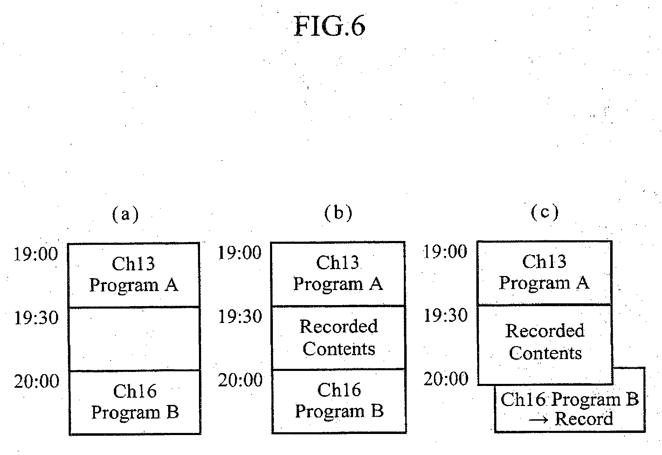

FIG. 6 is a diagram showing an arranging method of the viewing/listening schedule when a blank time occurs which does not include any programs with the fitness information not less than the prescribed value. In FIG. 6, a "CH13 program A" (referred to as program A from now on) and a "CH16 program B" (referred to as program B from now on) are broadcast programs with the fitness information not less than the prescribed value; and "recorded content" is a content stored in the content playback device 342, which is selected to fill in the blank time between the program A and the program B (referred to as the "blank time content" from now on).

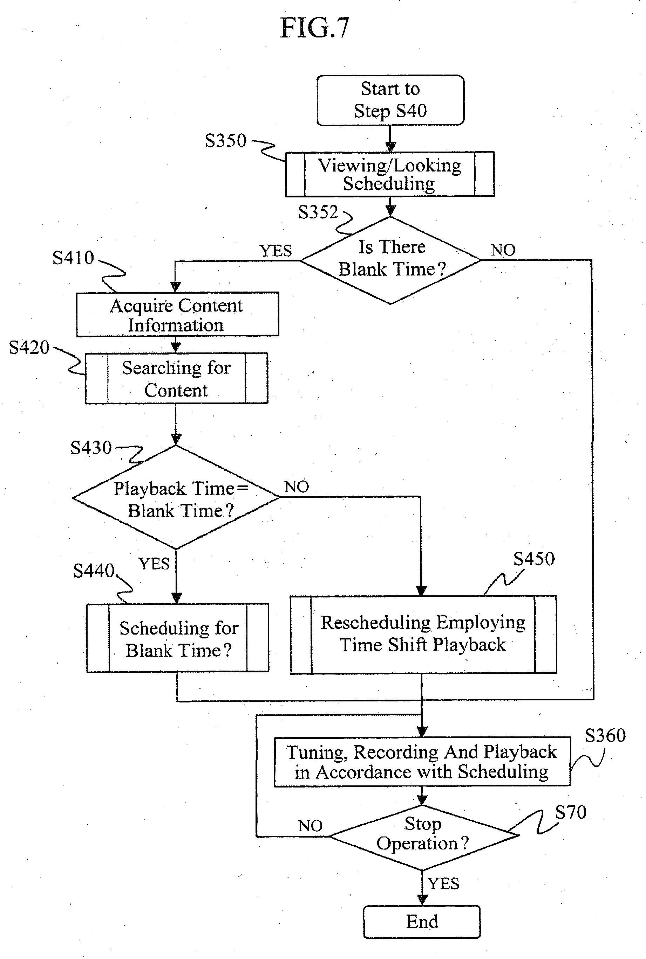

The operation will be described with reference to the flowchart of FIG. 7. Incidentally, as for the state of retaining the preference information on the broadcast program before starting the onboard tuning device 30 and as for step S10 - step S40, since they are the same as those of the example 1 or the embodiment 2, their description will be omitted here.

According to the broadcast time information and fitness information on each broadcast program fed from the preference fitness estimating unit 4, the viewing/listening scheduling unit 352 arranges a viewing/listening schedule by extracting programs with fitness information which is appropriate for the user's preference tendency and is greater than the prescribed value in the broadcast time slots from the present time to 12 hours after (step S350). Then, it makes a decision as to whether or not a blank time is present which does not include any programs with fitness information which is appropriate for the user's preference tendency and is greater than the prescribed value (step S352)

If the.blank time is hot present ("NO" at step S352),the processing proceeds to step S360 where the viewing/ listening control unit 351, which receives the viewing/listening schedule from the viewing/listening scheduling unit 352, controls the automatic tuning unit 36 and video/audio signal control unit 38 to successively provide the broadcast programs to which tuning is made according to the viewing/listening schedule (step S360 and step S70).

On the other hand, if the blank time is present between the finishing time of program A and the starting time of program B as shown in FIG. 6(a) (19:30 - 20:00) ("YES" at step S352), the viewing/listening scheduling unit 352 causes the individual recording devices 341 - 342 of the content retaining unit 340 to output information (content title, content itself, playback time and the like) on each content they store, and acquires the information on the contents stored in the content retaining unit 340 (step S410). Then, it searches for a content appropriate for the user's preference, which can fill in the blank time of 30 minutes between the program A and program B (total playback time is not less than the blank time) (step S420).

If the playback time of the blank time content searched for is equal to the blank time as shown in FIG. 6(b) ("YES" at step S430), the viewing/listening scheduling unit 352 arranges only the schedule within the blank time using the blank time content searched for (step S440). In this case, the number of the blank time contents is not limited to one. A plurality of contents are acceptable as long as they can cover 30 minutes or more, and the contents stored in the different recording units 341 - 342 can also be selected. The viewing/listening scheduling unit 352 supplies the viewing/listening schedule arranged to the viewing/listening control unit 351.

According to the viewing/listening schedule, the viewing/listening control unit 351 controls the automatic tuning unit 36 in such a manner as to tune to the program A during 19:00 - 19:30 so that the video/audio signal control unit 38 supplies the display unit 120 with the video and audio data of the program A output from the decoder unit 2. Then, the viewing/listening control unit 351 controls the content retaining unit 340 in such a manner as to output the playback signal of the content selected for the blank of 19 : 30 - 20 : 00 so that the video/audio signal control unit 38 supplies the display unit 120 with the video and audio data of the content for the blank output from the content retaining unit 340 (342). Then, at 20:00 the viewing/listening control unit 351 controls automatic tuning unit 36 in such a manner as to tune to the program B, and controls the video/audio signal control unit 38 in such a manner as to supply the display unit 120 with the video and audio data of the program B output from the decoder unit 2 (step S360). Unless a stop command is issued halfway, it controls in accordance with the schedule (step S70). Thus the program A, blank time content and program B are provided without interruption midway.

On the other hand, when the playback time of the blank time content searched for is longer than the blank time as shown in FIG. 6(c) ("NO" at step S430), the viewing/listening scheduling unit 351 employs the time-shift playback to reschedule the viewing/listening schedule (step S450). For example, when the total playback time of the blank time content in FIG. 6(c) is 40 minutes, the viewing/listening scheduling unit 352 selects the program A in 19:00 - 19:30, selects the content for the blank in 19:30 - 20:10, and selects the time-shift playback of the program B from 20:10. For example, if the broadcast time of the program B is 20:00 - 20:30, receiving the program B, it shifts the playback by 10 minutes from 20:10 to 20:40. As for the time slots thereafter, it reflects the shift of 10 minutes in the rescheduling. Then, it supplies the viewing/listening schedule rearranged to the viewing/listening control unit 351.

According to the viewing/listening schedule, the viewing/listening control unit 351 controls the automatic tuning unit 36 in such a manner as to tune to the program A during 19:00 - 19:30, and controls the video/audio signal control unit 38 in such a manner as to supply the video and audio data of the program A output from the decoder unit 2 to the display unit 120. Then, during 19:30 - 20:10, it controls the content retaining unit 340 in such a manner as to output the playback signal of the content for the blank selected, and controls the video/audio signal control unit 38 in such a manner as to supply the display unit 120 with the video and audio data of the content for the blank output from the content retaining unit 340. At 20: 00, it controls the automatic tuning unit 36 in such a manner as to tune to the program B, and controls the video/audio signal control unit 38 in such a manner as to supply the content recording/playback unit 341 with the video and audio data of the program B output from the decoder unit 2. Then, tuning to the program B and supplying the content recording/playback unit 341 with the video and audio data of the program B output from the decoder unit 2, it controls the content recording/playback unit 341 at 20:10 in such a manner as to play back the program B whose recording has been started from the beginning at 20:00, and controls the video/audio signal control unit 38 in such a manner as to supply the display unit 120 with the video and audio of the program B played back (step S360). After that, unless the stop command is issued halfway, it controls in accordance with the schedule (step S70). Thus, even if the content that exactly agrees with the length of the blank time is not retained, the program A, blank time content and program B are provided to the user without interruption midway.

In this way, while freeing the user from the tuning operation, it can successively provide the broadcast program or content fit for the user' s preference continuously without interruption midway.

As described above, according to the onboard tuning device of the embodiment 3 in accordance with the present invention 30, it is configured in such a manner that while recording the content of the broadcast program on the air, the content retaining unit 340 has the time-shift playback function of playing back the content by delaying the time, and that it includes the viewing/listening scheduling unit 352 for arranging, when the playback time of the content selected for the blank time exceeds the length of the blank time, the viewing/listening schedule in such a manner as to delay the playback time slot of the content of the broadcast program, the broadcast of which starts right after the blank time, to the time at which the playback of the content for the blank time completes, and the viewing/listening control unit 351 for controlling the content retaining unit 340, automatic tuning unit 36 and output signal control unit 38 in such a manner as to continue providing the contents fit for the user's preference in accordance with the viewing/listening schedule. Accordingly, it can successively provide broadcast programs with a high degree of matching for the user's preference continuously without requiring any tuning operation by the user. In other words, it can operate as it were a dedicated channel that can successively provide broadcast programs or contents the user likes continuously without requiring any tuning operation. Thus it can enable the driver to concentrate upon driving and to drive comfortably.

Incidentally, as the embodiment 2, it is obvious that the present embodiment 3 can also be configured in such a manner that when there are two or more programs with high preference fitness in the same time slot, it can store the broadcast programs in the content recording/playback unit 341 and play back after completing the broadcast of the broadcast programs stored.

Incidentally, the onboard tuning devices of the embodiments 2 - 3 can also be configured in such a manner as to provide ON/OFF settings of the automatic tuning so that they carry out the automatic tuning to the broadcast program fit for user preference in the ON setting, and do not carry out the automatic tuning in the OFF setting.

## Claims

1. An onboard tuning device comprising:
a program information acquiring unit (1, 2) for obtaining program list information;
a program information extracting unit (3) for extracting information on a program content and information on broadcast time for each broadcast program from the program list information acquired, and for outputting as program content information and broadcast time information on each broadcast program;
a preference information retaining unit (5) for storing preference tendency of a user for broadcast programs as preference information;
a preference matching estimating unit (4) for making a ranking based on a numerical grade as to the preference matching of each broadcast program for user's preference according to the preference information received from the preference information retaining unit and program content information received from the program information extracting unit, and for outputting as preference matching information;
a content retaining unit (240, 340) that has a time-shift playback function of shifting, while recording a content of a broadcast program on the air, time of the content and playing back the content whose time is shifted, and stores the content;
an output signal control unit for selecting and outputting a content stored in the content retaining unit in a blank time that does not have any broadcast programs with preference matching information equal to or more than a prescribed value;
a viewing/listening scheduling unit (352) for arranging, for a prescribed time slot from the present time, when a playback time slot of the content selected for the blank time exceeds the length of the blank time, a viewing/listening schedule in a manner as to delay a playback time slot of a content of a broadcast program whose broadcast begins immediately after the blank time to the time at which the playback of the content for the blank time is completed; and
an automatic tuning unit (6, 26, 36) for automatically tuning to a broadcast program with the highest preference matching information among broadcast programs during a designated time slot according to the broadcast time information and preference matching information,
**characterized in that**
the automatic tuning unit (6, 26, 36) automatically tunes to a broadcast program with the highest preference matching information among broadcast programs with the preference matching information equal to or more than the prescribed value wherein the output signal control unit:
selects, when a plurality of broadcast programs with the preference matching information equal to or more than the prescribed value are present in the designated time slot, a broadcast program as a program to be recorded, the broadcast program selected being a broadcast program other than the broadcast program to which the automatic tuning unit tunes in the designated time slot, and having the preference matching information equal to or more than a limit value set higher than the prescribed value; and
stores the content of the program to be recorded in the content retaining unit (240, 340).

2. The onboard tuning device according to claim 1, further comprising:
a viewing/listening control unit (351) for controlling the content retaining unit (340), the automatic tuning unit (36), and the output signal control unit (38) in accordance with the viewing/listening schedule.

3. The onboard tuning device according to any one of claims 1 - 2, wherein the output signal control unit deletes, when a content of a broadcast program stored in the content retaining unit has been played back, the content of the broadcast program played back from the content retaining unit (340).

4. The onboard tuning device according to any one of claims 1 - 3, further comprising a preference information analyzing unit (7) for reflecting, when detecting that a broadcast program to which manual tuning operation is made has been viewed/listened to for a time period longer than a prescribed time period, the program information on the broadcast program in the preference information.

## Patentansprüche

1. Bord-Tuning-Vorrichtung, umfassend:
eine Programminformations-Erfassungseinheit (1, 2) zum Ermitteln von Programmlisten-Information;
eine Programminformations-Extraktionseinheit (3) zum Extrahieren von Information zu einem Programminhalt und Information zu Rundfunkzeit für jedes Rundfunkprogramm aus der erfassten Programminformation, und zum Ausgeben einer Programminhalts-Information und Rundfunkzeitinformation zu jedem Rundfunkprogramm;
eine Präferenz-Informations-Halteeinheit (5) zum Speichern einer Präferenztendenz eines Anwenders für Rundfunkprogramme, als Präferenz-Information;
eine Präferenz-Passungs-Schätzeinheit (4) zur Durchführung einer Einstufung, basierend auf einem numerischen Grad, bezüglich der Präferenzpassung jedes Rundfunkprogramms für die Anwenderpräferenz anhand der aus der Präferenz-Informations-Halteeinheit empfangenen Präferenzinformation und aus der Programminformations-Extraktionseinheit empfangenen Programminhalts-Information, und zum Ausgeben als Präferenz-Passungs-Information;
eine Inhaltshalteeinheit (240, 340), die eine Zeitverschiebungs-Wiedergabefunktion zum Verschieben, während ein Inhalt eines Rundfunkprogramms, das ausgestrahlt wird, aufgezeichnet wird, der Zeit des Inhalts, und Wiedergeben des Inhalts, dessen Zeit verschoben ist, aufweist, und den Inhalt speichert;
eine Ausgangssignal-Steuereinheit zum Auswählen und Ausgeben eines in der Inhaltshalteeinheit gespeicherten Inhalts in einer Leerzeit, die keinerlei Rundfunkprogramme mit Präferenz-Passungs-Information gleich oder größer einem vorgegebenen Wert aufweist;
eine Anseh-/Anhör-Zeitplaneinheit (352) zum Anordnen, für einen vorgegebenen Zeitschlitz ab der aktuellen Zeit, wenn ein Wiedergabe-Zeitschlitz des für die Leerzeit ausgewählten Inhalts die Länge der Leerzeit übersteigt, eines Anseh-/Anhör-Zeitplans in einer Weise, welche einen Wiedergabe-Zeitschlitz eines Inhalt eines Rundfunkprogramms, dessen Ausstrahlung unmittelbar nach der Leerzeit beginnt, zu der Zeit verzögert, zu welcher die Wiedergabe des Inhalts für die Leerzeit abgeschlossen ist; und
eine Automatik-Tuning-Einheit (6, 26, 36) zum automatischen Tunen auf ein Rundfunkprogramm mit der höchsten Präferenz-Passungs-Information aus Rundfunkprogrammen während eines bezeichneten Zeitschlitzes gemäß der Rundfunkzeit-Information und Präferenz-Passungs-Information,
**dadurch gekennzeichnet, dass**
die Automatik-Tuning-Einheit (6, 26, 36) automatisch auf ein Rundfunkprogramm mit der höchsten Präferenz-Passungs-Information aus Rundfunkprogrammen mit der Präferenz-Passungs-Information gleich oder größer einem vorgegebenen Wert tunt, wobei die Ausgangssignal-Steuereinheit:
wenn eine Mehrzahl von Rundfunkprogrammen mit der Präferenz-Passungs-Information gleich oder größer dem vorgegebenen Wert in dem bezeichneten Zeitschlitz vorhanden sind, ein Rundfunkprogramm als ein aufzuzeichnendes Programm auswählt, wobei das ausgewählte Rundfunkprogramm ein anderes Rundfunkprogramm als das Rundfunkprogramm ist, auf welche die Automatik-Tuning-Einheit in dem bezeichneten Zeitschlitz tunt, und eine Präferenz-Passungs-Information gleich zu oder größer einem Grenzwert aufweist, der höher eingestellt ist als der vorgegebene Wert; und
den Inhalt des aufzuzeichnenden Programms in der Inhaltshalteeinheit (240, 340) speichert.

2. Bord-Tuning-Vorrichtung gemäß Anspruch 1, weiter umfassend:
eine Anseh-/Anhör-Steuereinheit (351) zum Steuern der Inhaltshalteeinheit (340), der Automatik-Tuning-Einheit (36) und der Ausgangssignal-Steuereinheit (38) gemäß dem Anseh-/Anhör-Zeitplan.

3. Bord-Tuning-Vorrichtung gemäß einem der Ansprüche 1 bis 2, wobei die Ausgangssignal-Steuereinheit, wenn ein Inhalt eines in der Inhaltshalteeinheit gespeicherten Rundfunkprogramms wiedergegeben worden ist, den Inhalt des wiedergegebenen Rundfunkprogramms aus der InhaltsHalteeinheit (340) löscht.

4. Bord-Tuning-Vorrichtung gemäß einem der Ansprüche 1 bis 3, weiter umfassend eine Präferenz-Informations-Analyseeinheit (7) zum Reflektieren, wenn detektiert wird, dass ein Rundfunkprogramm, zu welchem eine manuelle Tuning-Operation vorgenommen wird, für einen längeren Zeitraum als ein vorgegebener Zeitraum angesehen/angehört worden ist, der Programminformation an dem Rundfunkprogramm zu der Präferenz-Information.

## Revendications

1. Dispositif de syntonisation embarqué comprenant :
une unité d'acquisition d'informations de programme (1, 2) pour obtenir des informations de liste de programmes ;
une unité d'extraction d'informations de programme (3) pour extraire des informations concernant un contenu de programme et des informations concernant l'heure de diffusion pour chaque programme de diffusion à partir des informations de liste de programmes acquises, et pour les sortir en tant qu'informations de contenu de programme et informations d'heure de diffusion concernant chaque programme de diffusion ;
une unité de conservation d'informations de préférence (5) pour stocker une tendance de préférence d'un utilisateur pour des programmes de diffusion en tant qu'informations de préférence ;
une unité d'estimation de concordance à des préférences (4) pour établir un classement sur base d'un rang numérique quant à la concordance à des préférences de chaque programme de diffusion pour une préférence d'utilisateur selon les informations de préférence reçues en provenance de l'unité de conservation d'informations de préférence et selon les informations de contenu de programme reçues en provenance de l'unité d'extraction d'informations de programme, et pour les sortir en tant qu'informations de concordance à des préférences ;
une unité de conservation de contenu (240, 340) qui a une fonction de lecture en décalage consistant à décaler, tout en enregistrant un contenu d'un programme de diffusion en direct, l'heure du contenu et à lire le contenu dont l'heure est décalée, et qui stocke le contenu ;
une unité de commande de signal de sortie pour sélectionner et sortir un contenu stocké dans l'unité de conservation de contenu dans un temps d'inactivité qui n'a pas de quelconques programmes de diffusion avec des informations de concordance à des préférences égales ou supérieures à une valeur prescrite ;
une unité de planification de visualisation / écoute (352) pour agencer, pendant une tranche de temps prescrite à partir du temps présent, quand une tranche de temps de lecture du contenu sélectionnée pour le temps d'inactivité dépasse la longueur du temps d'inactivité, un horaire de visualisation / écoute de manière à retarder une tranche de temps de lecture d'un contenu d'un programme de diffusion dont la diffusion commence immédiatement après le temps d'inactivité jusqu'au moment auquel la lecture du contenu pour le temps d'inactivité est achevée ; et
une unité de syntonisation automatique (6, 26, 36) pour syntoniser automatiquement sur un programme de diffusion avec les informations de concordance à des préférences les plus élevées parmi des programmes de diffusion pendant une tranche de temps désignée selon les informations d'heure de diffusion et les informations de concordance à des préférences,
**caractérisé en ce que**
l'unité de syntonisation automatique (6, 26, 36) syntonise automatiquement sur un programme de diffusion avec les informations de concordance à des préférences les plus élevées parmi des programmes de diffusion, les informations de concordance à des préférences étant égales ou supérieures à la valeur prescrite dans laquelle l'unité de commande de signal de sortie :
sélectionne, quand une pluralité de programmes de diffusion avec les informations de concordance à des préférences étant égales ou supérieures à la valeur prescrite, sont présents dans la tranche de temps désignée, un programme de diffusion en tant qu'un programme à enregistrer, le programme de diffusion sélectionné étant un programme de diffusion autre que le programme de diffusion sur lequel l'unité de syntonisation automatique syntonise dans la tranche de temps désignée, et ayant les informations de concordance à des préférences égales ou supérieures à une valeur limite fixée supérieure à la valeur prescrite ; et
stocke le contenu du programme à enregistrer dans l'unité de conservation de contenu (240, 340).

2. Dispositif de syntonisation embarqué selon la revendication 1, comprenant en outre :
une unité de commande de visualisation / écoute (351) pour commander l'unité de conservation de contenu (340), l'unité de syntonisation automatique (36), et l'unité de commande de signal de sortie (38) selon l'horaire de visualisation / écoute.

3. Dispositif de syntonisation embarqué selon l'une quelconque des revendications 1 - 2, dans lequel l'unité de commande de signal de sortie supprime, quand un contenu d'un programme de diffusion stocké dans l'unité de conservation de contenu a été lu, le contenu du programme de diffusion lu en provenance de l'unité de conservation de contenu (340).

4. Dispositif de syntonisation embarqué selon l'une quelconque des revendications 1 - 3, comprenant en outre une unité d'analyse d'informations de préférence (7) pour refléter, en détectant qu'un programme de diffusion sur lequel une opération de syntonisation manuelle est faite a été visualisé / écouté pour une période de temps plus longue qu'une période de temps prescrite, les informations de programme concernant le programme de diffusion dans les informations de préférence.
